(19) Europäisches Patentamt
European Patent Office
Office européen des brevets

(11) **EP 3 955 406 A1**

(12) **EUROPEAN PATENT APPLICATION**

(43) Date of publication:
**16.02.2022 Bulletin 2022/07**

(21) Application number: **20190327.5**

(22) Date of filing: **10.08.2020**

(51) International Patent Classification (IPC):
*H02H 9/04* (2006.01)     *H02J 7/00* (2006.01)

(52) Cooperative Patent Classification (CPC):
**H02H 9/04; H02J 7/0031**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Valeo Siemens eAutomotive Norway AS**
**3036 Drammen (NO)**

(72) Inventor: **Sørsdahl, Torbjørn**
**3036 Drammen (NO)**

(74) Representative: **Gevers & Orès**
**Immeuble le Palatin 2**
**3 Cours du Triangle**
**CS 80165**
**92939 Paris La Défense Cedex (FR)**

(54) **ELECTRICAL SYSTEM WITH A CIRCUIT FOR PROTECTING AN ELECTRICAL COMPONENT FROM DAMAGEFUL CURRENT**

(57)     The electrical system (102) comprises two supply lines (L+, L-) between which the electrical component (C) is connected and a voltage limiting circuit (124) for limiting a switch voltage (Vmos) across a controllable switch (118) of the protecting circuit (116) placed on a selected one (L-) of the supply lines (L+, L-) to a portion of a maximum of a main DC voltage (Vbat) provided by a main DC voltage source connected between the supply lines (L+, L-) when the controllable switch (118) is open.

Figure 1

## Description

The present invention relates to an electrical system with a circuit for protecting an electrical component from damaging current.

It is known to use an electrical system comprising:

- two supply lines comprising two respective end points intended to be connected to a main DC voltage source;

- an electrical component connected between the supply lines; and

- a protecting circuit for protecting the electrical component from damaging current, the protecting circuit being placed on a selected one of the supply lines, between the end point of the selected supply line and the electrical component, and designed to selectively: let current pass on the selected supply line, and prevent current from passing on the selected supply line to reach the electrical component, the current limiting circuit comprising a controllable switch placed on the selected line.

The controllable switch is for example an electrical relay or a semiconductor switch, while the main DC voltage source is for example a battery and the electrical system comprises a charger of the electrical battery. In this case, the electrical component is usually an output capacitance arranged for smoothing a charging voltage provided by the charger. When the battery is to be charged, the protecting circuit is set to let current pass by closing the controllable switch.

When the battery is not being charged, it is usually used to power other electrical devices. These electrical devices may generate a noise voltage at high frequency across the two supply lines. This happens in particular when the electrical devices comprise electrical switches operating at high frequency. Without the protection circuit, the noise voltage would be applied across the output capacitance, leading to a very high current going through the output capacitance that could damage the output capacitance. That is why, when the battery is not being charged, the protecting circuit is set to prevent such damaging current from passing on the selected supply line to reach the output capacitance, by opening the controllable switch so as to cut the selected supply line.

When the protecting circuit prevents current from passing on the selected supply line, it may receive the whole main DC voltage. For example, when the charger is not operating, the output capacitance may discharge over time so that voltage across the output capacitance is zero. The controllable switch of the protecting circuit must therefore be designed to support the main DC voltage, which can be very high. This leads to a very costly controllable switch, in particular when it is a semiconductor switch.

The invention aims to overcome at least in part the previously mentioned drawback of the prior art.

An object of the invention is therefore an electrical system:

- two supply lines comprising two respective end points intended to be connected to a main DC voltage source;

- an electrical component connected between the supply lines; and

- a protecting circuit for protecting the electrical component from damaging current, the protecting circuit being placed on a selected one of the supply lines, between the end point of the selected supply line and the electrical component, and designed to selectively: let current pass on the selected supply line, and prevent current from passing on the selected supply line to reach the electrical component, the current limiting circuit comprising a controllable switch placed on the selected line;

characterized in that it further comprises:

- a voltage limiting circuit for limiting a switch voltage across the controllable switch to a portion of a maximum of a main DC voltage provided by the main DC voltage source when the controllable switch is open.

Thanks to the invention, the voltage across the controllable switch is limited to only a portion of the main DC voltage, so that the controllable switch needs only to be designed to support this portion of the main DC voltage and not the whole DC voltage.

Optionally, the portion is less than 10% of the maximum of the main DC voltage.

Also optionally, the voltage limiting circuit comprises a first resistor connected across the supply lines and a second resistor connected across the controllable switch.

Also optionally, the first resistor is at least ten times greater than the second resistor.

Also optionally, the voltage limiting circuit further comprises a Zener diode in series with a series resistance forming at least in part the second resistor, the Zener diode and the series resistance being both connected across the controllable switch.

Also optionally, the voltage limiting circuit comprises an auxiliary DC voltage source connected across the controllable switch for applying a limiting voltage across the controllable switch.

Also optionally, the auxiliary DC voltage source is arranged to be powered by the main DC voltage source.

Also optionally, the auxiliary DC voltage source comprises a closed loop for stabilizing the limiting voltage.

Also optionally, the electrical system further comprises a voltage dependent resistor connected across the controllable switch for receiving the switch voltage, the voltage dependent resistor having a resistance decreasing as the switch voltage increases.

Also optionally, the electrical component comprises a capacitance.

Also optionally, the main DC voltage source comprises a battery.

Also optionally, the electrical system further comprises a charger for charging the battery.

Another object of the invention is a method of operating an electrical system according to the invention, comprising:

- setting the protecting circuit to prevent current from passing on the selected supply line to reach the electrical component when a noise voltage source is active and providing a noise voltage between the end points of the supply lines; and

- setting the protecting circuit to let current pass on the selected supply line when the noise voltage source is inactive.

These and other features, aspects, and advantages of the present invention will become better understood when the following detailed description is read with reference to the accompanying drawings, in which:

[Fig. 1] figure 1 is an electrical circuit diagram representing an electrical system according to a first embodiment of the invention,

[Fig. 2] figure 2 is a block diagram representing steps of a method of operation of the electrical system of figure 1,

[Fig. 3] figure 1 is an electrical circuit diagram representing an electrical system according to a second embodiment of the invention, and

[Fig. 4] figure 4 is an electrical circuit diagram representing an electrical system according to a third embodiment of the invention.

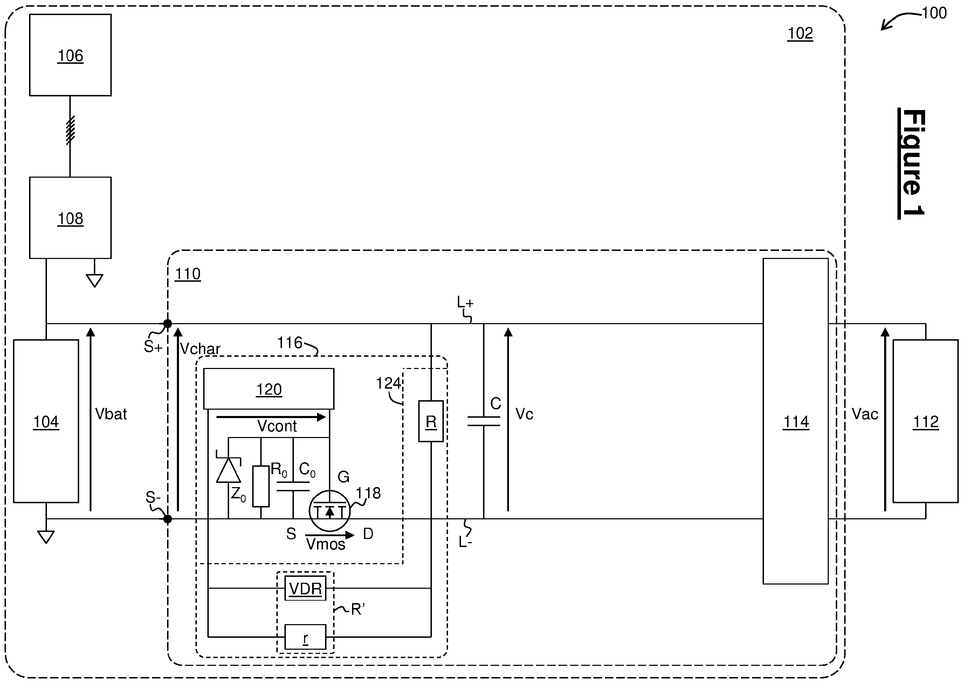

Referring to figure 1, an installation 100 comprising an example of electrical system 102 according to the invention will now be described.

In the described example, the electrical system 102 is part of an electric car or a hybrid car.

The electrical system 102 comprises a main DC voltage source 104 for providing a main DC voltage Vbat. In the described example, the main DC voltage source 104 comprises a battery. The main DC voltage Vbat may vary over time, for example depending on a charge level of the battery. For example, the main DC voltage Vbat may vary between a maximum main DC voltage (for example when the battery is fully charged) and a value lower than this maximum DC voltage. The maximum main DC voltage is a high voltage usually greater than 100 V, for example comprised between 300 V and 1 000 V.

In the described example, the electrical system 102 further comprises an electrical machine 106 and an inverter 108 for converting the main DC voltage Vbat into phase AC voltages for the electrical machine 106. For example, the electrical machine 106 is designed for driving wheels of the car, in addition to a heat engine in the case of a hybrid car.

The electrical system 102 further comprises, in the described example, a charger 110 for charging the battery of the main DC voltage source 104 from an AC voltage Vac of an AC voltage source 112 of the installation 100. The AC voltage source 112 comprises for example a local or global electrical grid.

The charger 110 is for example an "on-board charger" or OBC. The charger 110 comprises in particular two supply lines L+, L- comprising two respective end points S+, S- connected to the main DC voltage source 104. The end point S- of the low supply line L- is connected to a ground of the installation 100. The charger 110 further comprises, in the described example, a rectifier 114 for rectifying the AC voltage Vac so that the charger 110 can provide, between the two end points S+, S-, a charge DC voltage Vchar.

The charger 110 further comprises an electrical component connected between the supply lines L+, L-. In the described example, the electrical component is an output capacitance C for smoothing the charge DC voltage Vchar. The capacitance voltage across the output capacitance C is noted Vc.

The charger 110 further comprises a protecting circuit 116 placed, in the described example, on the low supply line L-, between its end point S- and the output capacitance C.

The protecting circuit 116 comprises a controllable switch 118 placed on the low supply line L-. In the described example, the controllable switch 118 comprises a semiconductor switch such as a MOSFET (metal-oxide-semiconductor field-effect transistor) or an IGBT (insulated-gate bipolar transistor). In the described example, a MOSFET is used. The semiconductor switch comprises a first terminal D (called drain and source for the MOSFET) and a second terminal S (called source for the MOSFET) both located on the low supply line L-. The semiconductor switch further comprises a control terminal G (called gate for the MOSFET). The second terminal S is connected to the end points S-, while the first terminal D is connected to the output capacitance C. The switch voltage across the controllable switch 118 is noted Vmos.

The controllable switch 118 is designed for receiving a control signal Vcont for selectively being opened and closed. To this end, the protecting circuit 116 further comprises a control device 120 for controlling the controllable switch 118 by providing the control signal Vcont. In the described example, the control signal Vcont is a control voltage between the control terminal G and the second terminal S.

The protecting circuit 116 further comprises a capacitance $C_0$ and a resistance $R_0$ both connected between the control terminal G and the second terminal S, for avoiding parasitic turn-on of the controllable switch 118. It further comprises a Zener diode $Z_0$ connected between the control terminal G and the second terminal S, for protecting the control terminal G from overvoltage.

The protecting circuit 116 further comprises a voltage dependent resistor VDR connected across the controllable switch 118 (i.e. between its terminals S and D) for receiving the switch voltage Vmos. The voltage dependent resistor VDR is designed to have a resistance decreasing as the switch voltage Vmos increases.

The protecting circuit 116 further comprises a voltage limiting circuit 124 for limiting the switch voltage Vmos to a portion of the main DC voltage Vbat when the controllable switch 118 is open. For example, this portion of the main DC voltage Vbat is less than 10% of the maximum main DC voltage Vbat. In the example of figure 1, the voltage limiting circuit 124 comprises a first resistance R connected across the supply lines L+, L-, and a second resistance R' connected across the controllable switch 118. In the described example, the second resistor R' comprises the voltage dependent resistance VDR and an auxiliary resistance r in parallel to the voltage dependent resistance VDR. The value of the resistance r is for example set for the AC voltage ripple to be low.

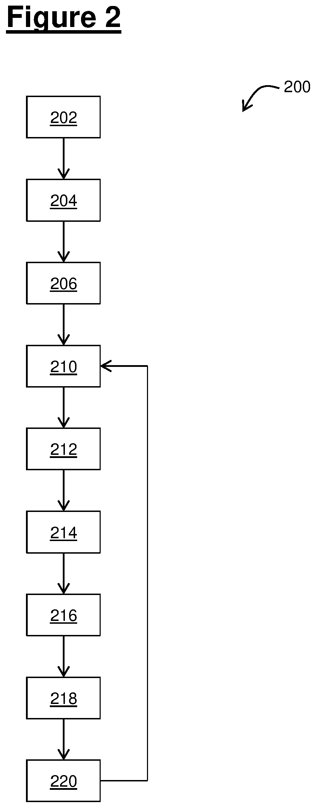

Referring to figure 2, an example of method 200 of operation of the installation 100 will now be described.

Initially, at a step 202, the controllable switch 118 is open and the output capacitance C is discharged. The inverter 108 and the electrical machine 106 are turned off. The charger 110 is disconnected from the main DC voltage source 104 and from the AC voltage source 112.

At a step 204, the charger 110 is connected to the main DC voltage source 104. The step 202 may occur for example during assembly of the car or after the main DC voltage source 104 was disconnected for maintenance. Because the output capacitance C is discharged, the capacitance voltage Vc is equal to zero so that, in the absence of the voltage dependent resistor VDR, the main DC voltage Vbat would be abruptly applied across the controllable switch 118, i.e. the switch voltage Vmos would become abruptly equal to the main DC voltage Vbat, which could damage the controllable switch 118. However, as explained previously, when the switch voltage Vmos increases, the voltage dependent resistance VDR exhibits a lowering resistance, so that the voltage dependent resistance VDR short-circuits the controllable switch 118. In this manner, the switch voltage Vmos stays low so that the battery voltage Vbat is present across resistances (not shown) such as an output resistance of the main DC voltage source 104. It will be appreciated that the voltage dependent resistance VDR also protects the controllable switch 118 in case of a thunder lightning causing a quick overvoltage between the end point S- and the low supply line L-.

At a step 206, the output capacitance C is charging so that the capacitance voltage Vc increases to almost the battery voltage Vbat and the switch voltage Vmos decreases to almost zero. More precisely, the switch voltage Vmos is limited to:

[Math. 1]

$$Vmos = \frac{R'}{R' + R}Vbat \approx \frac{r}{r + R}Vbat$$

At a step 210, the inverter 108 and the electrical machine 106 are turned on. Because of their internal electronic switches, they produce AC noise voltage at high frequency that adds up to the main DC voltage Vbat between the end points S+ and S-. The AC noise voltage has a voltage amplitude Vnoise of usually between 10 V and 20 V. However, with the controllable switch 118 open, the protecting circuit 116 exhibits a very high resistance between S- and the output capacitance C. More precisely, the controllable switch 118 substantially form an open circuit while the resistance R' (i.e. the resistance r in the described example) is very high. Preferably, the resistance R' is designed so that the switch voltage Vmos is at least 50% of the voltage amplitude Vnoise of the AC noise voltage. In this case, R' is for example such that:

[Math. 2]

$$R' \geq \frac{1}{2\,Vbat/Vnoise - 1}R$$

In the described example, the resistance R is equal to 990 k$\Omega$, while the resistance R' (i.e. the resistance r in the described example) is equal to 10 k$\Omega$. With such high resistance R', the current passing in the output capacitor C resulting from the AC noise voltage stays very low. Because of the capacitance C, the current may flow alternatively in the forward direction and in the reverse direction of the controllable switch (from terminal S to terminal G, for example through a body diode not illustrated). However, thanks to the high resistance R', the current passing in the reverse direction of the controllable switch 118 is very low.

At a step 212, the inverter 108 and the electrical machine 106 are turned off, which stops the AC noise voltage.

At a step 214, the control device 120 closes the controllable switch 118 to let current pass on the low supply line L-.

At a step 216, the charger 110 is connected to the AC voltage source 112 so as to provide the charge DC voltage Vchar between the end points S+, S- for charging the battery of the main DC voltage source 104.

At a step 218, the charger 110 is turned off and disconnected from the AC voltage source 112.

At a step 220, the control device 120 opens the controllable switch 118.

The method 200 may then go back to the step 210 for a new discharge/charge cycle of the battery 104 or the battery 104 may be disconnected, for example for maintenance.

In the embodiment of figure 1, the controllable switch 118 must be designed to support, when open, the switch voltage Vmos for the least favorable case, that is to say for the maximum main DC voltage Vbat (see equation Math. 1 above).

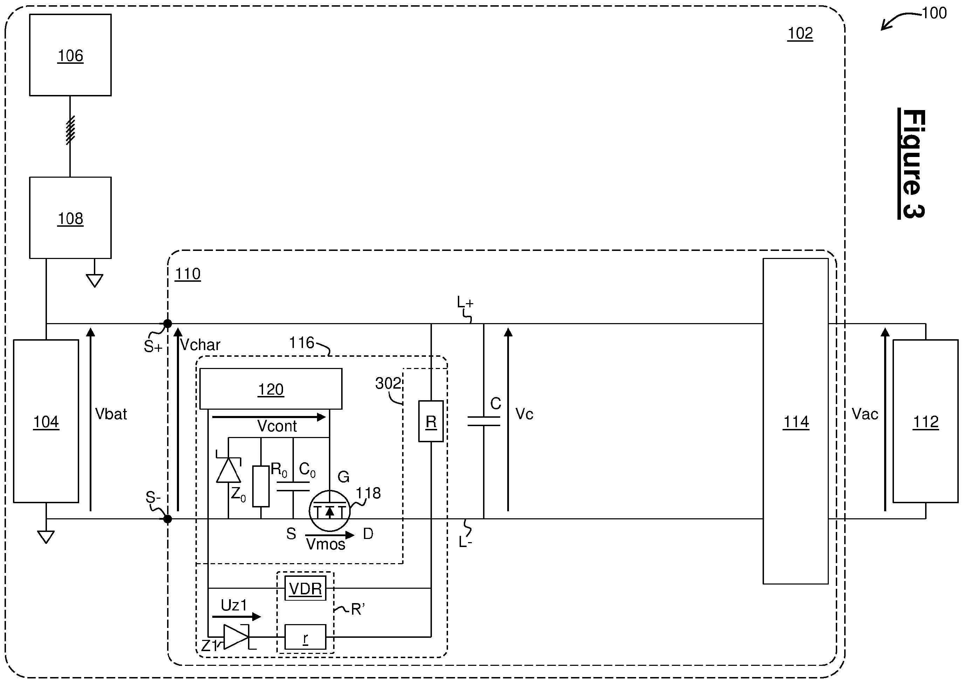

To overcome this drawback, referring to figure 3, in another embodiment of the invention, the voltage limiting circuit, now referenced 302, further comprises a Zener diode Z1 in series with the resistor r, both connected across the controllable switch 118. The Zener diode Z1 has a breakdown reverse voltage noted Uz1.

The resistor r is to avoid that the Zener diode Z1 acts as a short circuit for the AC voltage ripple. Zener diode Z1 do not conduct before the voltage Uz1 is present.

So the Zener diode Z1 reduces greatly the variation of the voltage Vmos due to the variation of the battery voltage Vbat coming from the charge/discharge cycles of the battery 104. This reduces the voltage requirement of the VDR.

The method 200 applies to the installation 100 of figure 3.

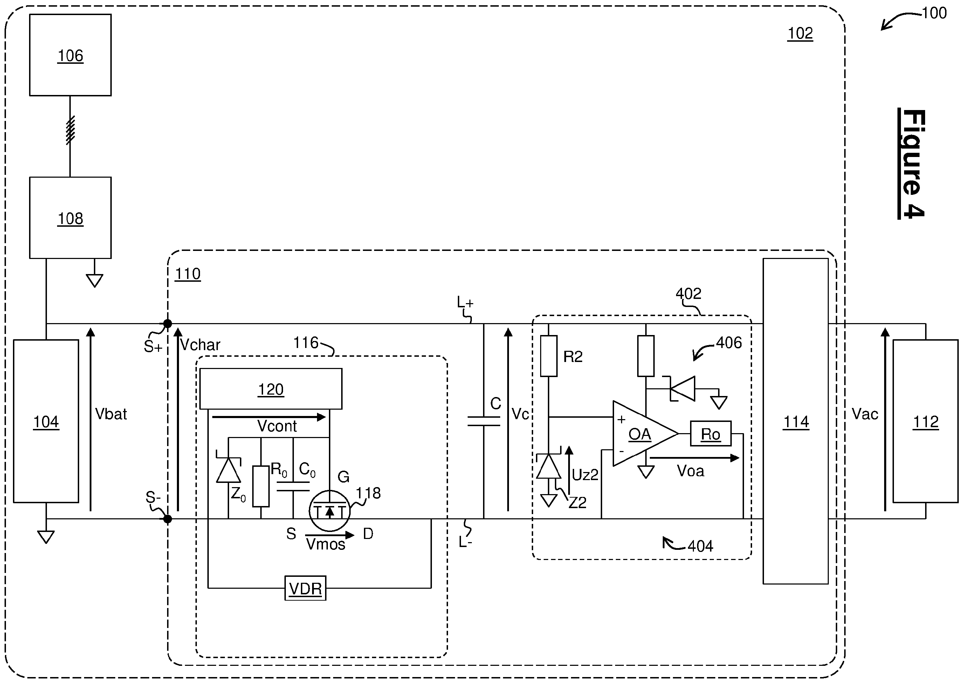

Referring to figure 4, in another embodiment of the invention, the voltage limiting circuit, now referenced 402, comprises an auxiliary DC voltage source 404 for applying a limiting voltage Voa across the controllable switch 118. The auxiliary DC voltage source 404 is designed such that the limiting voltage Voa is a portion of the maximum main DC voltage Vbat. For example the limiting voltage Voa is less than 10% of the main DC voltage Vbat.

More precisely, in the described example, the auxiliary DC voltage source 404 comprises a Zener diode Z2 having a breakdown reverse voltage Uz2. The Zener diode Z2 is arranged to provide this reverse voltage Uz2. In the described example, the Zener diode Z2 is arranged to be powered by the main DC voltage source 104. To this end, the auxiliary DC voltage source 404 comprises a resistance R2 connecting a cathode of the Zener diode Z2 to the line L+, while an anode of the Zener diode Z2 is connected to the ground.

The voltage limiting circuit 402 further comprises a voltage copying circuit 406 for supplying the limiting voltage Voa as a copy of the reverse voltage Uz2. In the described example, the voltage copying circuit 406 comprises an operational amplifier OA comprising a positive input connected to the Zener diode Z2 to receive the reverse voltage Uz2, a negative input and an output. The negative input is directly connected to the terminal D of the controllable switch 118, while the output is connected to terminal D of the controllable switch 118 through an output resistance Ro.

The operational amplifier OA is connected between the high supply line L+ and the ground to be powered by the main DC voltage source 104.

From what precedes, in the described example, the auxiliary DC voltage source 404 is designed to be powered by the main DC voltage source 104. Also in the described example, the auxiliary DC voltage source 404 comprises a closed loop (the output of the operational amplifier is connected to its negative input) for stabilizing the limiting voltage Voa to the reverse voltage Uz2. It will be appreciated that, in the described example, the auxiliary DC voltage source 404 is a high impedance supply voltage follower.

The method 200 applies to the installation 100 of figure 4, except that, at step 208, the limitation of the switch voltage Vmos is obtained by the fact that the auxiliary DC voltage source 404 applies the limiting voltage Voa (which is a stabilized copy of the reverse voltage Uz2) across the controllable switch 118 so that the switch voltage Vmos is equal to the limiting voltage Voa.

It is clear that an electrical system such as those described above allows the use of a controllable switch designed for low voltages when it is open.

The invention is not limited to the embodiments described above. It will appear to those normally skilled in the art that various modifications can be made to the embodiments described above, in the light of the teaching which has just been disclosed to them.

In the detailed presentation of the invention which is made previously, the terms used should not be interpreted as limiting the invention to the embodiments set out in this description, but should be interpreted to include all the equivalents within the reach of those normally skilled in the art by applying their general knowledge to the implementation of the teaching which has just been disclosed to them.

**Claims**

1. Electrical system (102) comprising:

    - two supply lines (L+, L-) comprising two respective end points (S+, S-) intended to be connected to a main DC voltage source (104);
    - an electrical component (C) connected between the supply lines (L+, L-); and
    - a protecting circuit (116) for protecting the electrical component (C) from damaging current, the protecting circuit (116) being placed on a selected one (L-) of the supply lines (L+, L-), between the end point (S-) of the selected supply line (L-) and the electrical component (C), and designed to selectively: let current pass on the selected supply line (L-), and prevent current from passing on the selected supply line (L-) to reach the electrical component (C), the protecting circuit (116) comprising a controllable switch (118) placed on the selected line (L-);

**characterized in that** it further comprises:

- a voltage limiting circuit (124; 302; 402) for limiting a switch voltage (Vmos) across the controllable switch (118) to a portion of a maximum of a main DC voltage (Vbat) provided by the main DC voltage source when the controllable switch (118) is open.

2. Electrical system (102) according to claim 1, wherein the portion is less than 10% of the maximum of the main DC voltage (Vbat).

3. Electrical system (102) according to claim 1 or 2, wherein the voltage limiting circuit (124; 302) comprises a first resistor (R) connected across the supply lines (L+, L-) and a second resistor (R') connected across the controllable switch (118).

4. Electrical system (102) according to claim 3, wherein the first resistor (R) is at least ten times greater than the second resistor (R').

5. Electrical system (102) according to claim 2 or 3, wherein the voltage limiting circuit (302) further comprises a Zener diode (Z1) in series with a series resistance (r) forming at least in part the second resistor (R'), the Zener diode (Z1) and the series resistance (r) being both connected across the controllable switch (118).

6. Electrical system (102) according to claim 1 or 2, wherein the voltage limiting circuit (402) comprises an auxiliary DC voltage source (404) connected across the controllable switch (118) for applying a limiting voltage (Voa) across the controllable switch (118).

7. Electrical system (102) according to claim 6, wherein the auxiliary DC voltage source (404) is arranged to be powered by the main DC voltage source (104).

8. Electrical system (102) according to 6 or 7, wherein the auxiliary DC voltage source (404) comprises a closed loop for stabilizing the limiting voltage (Voa).

9. Electrical system (102) according to any of claims 1 to 8, further comprising a voltage dependent resistor (VDR) connected across the controllable switch (118) for receiving the switch voltage (Vmos), the voltage dependent resistor (VDR) having a resistance decreasing as the switch voltage (Vmos) increases.

10. Electrical system (102) according to any of claims 1 to 9, wherein the electrical component comprises a capacitance (C).

11. Electrical system (102) according to any of claims 1 to 10, wherein the main DC voltage source (104) comprises a battery.

12. Electrical system (102) according to claim 11, further comprising a charger (110) for charging the battery.

13. Method (200) of operating an electrical system (102) according to any of claims 1 to 12, comprising:

- setting the protecting circuit (116) to prevent current from passing on the selected supply line (L-) to reach the electrical component (C) when a noise voltage source (106, 108) is active and providing a noise voltage between the end points (S+, S-) of the supply lines (L+, L-); and
- setting the protecting circuit (116) to let current pass on the selected supply line (L-) when the noise voltage source (106, 108) is inactive.

**Figure 1**

# Figure 2

# Figure 3

# Figure 4

Europäisches
Patentamt

European
Patent Office

Office européen
des brevets

# EUROPEAN SEARCH REPORT

Application Number

EP 20 19 0327

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 914 542 A (WEIMER JOSEPH A [US] ET AL) 22 June 1999 (1999-06-22) | 1-5,9-13 | INV.<br>H02H9/04<br>H02J7/00 |
| A | * column 10, line 65 - column 12, line 3; figure 3 * | 6-8 | |
| X | US 2010/171468 A1 (BRERETON RICHARD PETER [GB] ET AL) 8 July 2010 (2010-07-08) | 1 | |
| A | * paragraphs [0053] - [0059]; figure 6 * | 6-8 | |
| A | US 2018/240629 A1 (AO XIANG [CN]) 23 August 2018 (2018-08-23) * paragraphs [0051] - [0057]; figures 1, 3, 4 * | 1,13 | |

TECHNICAL FIELDS
SEARCHED    (IPC)

H02H
H02J

The present search report has been drawn up for all claims

| Place of search | Date of completion of the search | Examiner |
|---|---|---|
| Munich | 15 January 2021 | Colombo, Alessandro |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 20 19 0327

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2021

| Patent document cited in search report | | Publication date | Patent family member(s) | | Publication date |
|---|---|---|---|---|---|
| US 5914542 | A | 22-06-1999 | NONE | | |
| US 2010171468 | A1 | 08-07-2010 | GB<br>US | 2466804 A<br>2010171468 A1 | 14-07-2010<br>08-07-2010 |
| US 2018240629 | A1 | 23-08-2018 | CN<br>EP<br>US | 108469584 A<br>3367411 A1<br>2018240629 A1 | 31-08-2018<br>29-08-2018<br>23-08-2018 |

EPO FORM P0459

For more details about this annex : see Official Journal of the European Patent Office, No. 12/82